# EUROPÄISCHE PATENTSCHRIFT

(11) **EP 1 518 450 B1**
(45) Veröffentlichungstag und Bekanntmachung des Hinweises auf die Patenterteilung: **21.12.2005**
(21) Anmeldenummer: 04739644.5
(22) Anmeldetag: 05.06.2004
(51) Int. Cl.: H05K 7/20, F04D 29/66, F04D 25/12

(54) **MINI FILTER ZUR BEFESTIGUNG IN EINER AUSNEHMUNG EINER WAND**
MINI FAN TO BE FIXED IN A RECESS OF A WALL
MINI-VENTILATEUR A FIXER DANS UN CREUX D'UNE PAROI

(30) Priorität: 15.07.2003 DE 20311309 U
(43) Veröffentlichungstag der Anmeldung: 30.03.2005
(73) Patentinhaber: ebm-papst St. Georgen GmbH & Co. KG, 78112 St. Georgen (DE)
(72) Erfinder: WINKLER, Wolfgang, Arno, 78112 St. Georgen (DE); RAPP, Nils, 78112 St. Georgen (DE)
(74) Vertreter: Raible, Tobias
(86) Internationale Anmeldenummer: PCT/EP2004/006102
(87) Internationale Veröffentlichungsnummer: WO 2005/009098

(56) Entgegenhaltungen:
- US-A- 4 819 503
- US-A- 5 208 730
- US-A1- 2002 060 900

## Beschreibung

Die Erfindung betrifft einen Minilüfter zur Befestigung in einer Ausnehmung einer Wand.

Minilüfter, auch Klein- oder Kleinstlüfter genannt, dienen z.B. zur Kühlung von Prozessoren in Computern, zur Gerätekühlung bei kleinen Geräten, etc., und sie haben sehr kleine Abmessungen. Z.B. haben
- die Lüfter der ebm-papst-Serie 250 Abmessungen von 8 x 25 x 25 mm,
- die der ebm-papst-Serie 400F Abmessungen von 10 x 40 x 40 mm,
- die der ebm-papst-Serie 400 von 20 x 40 x 40 mm,
- und die Lüfter der ebm-papst-Serie 600 von 25,4 x 60 x 60 mm.
Die Leistungsaufnahme solcher Lüfter liegt bei der Serie 250 bei 0,4 ... 0,6 W, bei der Serie 400F bei 0,7...0,9 W, und bei den Serien 400 und 600 bei 0,9...1,6 W.

Bei Minilüftern ist es derzeit üblich, sie mittels Schrauben zu befestigen. Andere Lüfter zur Befestigung in einer Ausnehmung einer Wand sind aus der US 4 819 503 oder aus der US 2002 / 060 900 bekannt. Dies hat jedoch den Nachteil, dass über diese Befestigung Körperschall vom Lüfter auf eine Wand übertragen werden kann, was die Geräusche entsprechend verstärkt. Zudem ist diese Art der Befestigung kostenaufwändig.

Es ist deshalb eine Aufgabe der Erfindung, einen neuen Minilüfter bereit zu stellen, welcher auf einfache Weise an einer Ausnehmung einer Wand befestigt werden kann.

Nach der Erfindung wird diese Aufgabe gelöst durch den Gegenstand des Anspruchs 1. Die Erfindung ermöglicht eine Zwangs-Translationsbewegung des Lüfters in Richtung zu einer Öffnung, an der dieser Lüfter installiert werden soll, und hierbei wird in einem elastischen Glied potenzielle Energie gespeichert, z.B. durch elastische Verformung des elastischen Glieds. Die Translationsbewegung kann dabei etwa senkrecht zur Achse dieser Wandöffnung erfolgen, also quer zu dieser Achse. Bei Erreichen der gewünschten Stellung relativ zur Öffnung wird mindestens ein Teil dieser gespeicherten potenziellen Energie in kinetische Energie umgewandelt, um einen Bestandteil des Lüfters in diese Öffnung zu verschieben und dabei gleichzeitig ein Dichtglied zu aktivieren, das eine Dichtung zwischen dem Gehäuse des Lüfters und den die Öffnung umgebenden Wandabschnitten herstellt. Bevorzugt kann ein Teil der bei der Translationsbewegung gespeicherten Energie dazu verwendet werden, eine ständige Kraft auf diese Dichtung zu erzeugen, d.h. auch im montierten Zustand des Lüfters bleibt bevorzugt genügend potenzielle Energie gespeichert, um den abgedichteten Zustand ständig aufrecht zu erhalten.

Durch ein geschicktes "Energiemanagement" beim Montagevorgang kann also die Montage solcher Minilüfter sehr einfach und preiswert durchgeführt werden, nämlich ohne Werkzeug, wobei zusätzlich der Vorteil entsteht, dass die direkte Übertragung von Körperschall vom Lüfter auf ein umgebendes Gehäuse zumindest stark reduziert wird. Man erreicht so, dass der Lüfter in sehr einfacher Weise und mit guter Abdichtung befestigt werden kann, wobei bevorzugt die Übertragung von Körperschall des Lüfters auf die benachbarte Wand nur gedämpft erfolgt, so dass insgesamt der Geräuschpegel gesenkt wird.

Weitere Einzelheiten und vorteilhafte Weiterbildungen der Erfindung ergeben sich aus den im folgenden beschriebenen und in der Zeichnung dargestellten, in keiner Weise als Einschränkung der Erfindung zu verstehenden Ausführungsbeispielen, sowie aus den Unteransprüchen. Es zeigt:
- Fig. 1: eine Draufsicht auf eine Gehäusewand mit einer im wesentlichen runden Ausnehmung, in der ein im wesentlichen runder Lüfter nach einem ersten Ausführungsbeispiel der Erfindung befestigt ist; Fig. 1 ist aus Gründen der Darstellung etwas vergrößert gezeichnet,
- Fig. 2: eine seitliche Ansicht, gesehen in Richtung des Pfeiles II der Fig. 1,
- Fig. 3: eine seitliche Ansicht, gesehen in Richtung des Pfeiles III der Fig. 1,
- Fig. 4: eine seitliche Ansicht, gesehen in Richtung des Pfeiles IV der Fig. 1,
- Fig. 5: eine Schnittdarstellung ähnlich Fig. 6 zur Erläuterung des Montagevorgangs,
- Fig. 6: einen Schnitt analog Fig. 5, gesehen längs der Linie VI-VI der Fig. 1 in stark vergrößerter Darstellung; der Motor ist nur schematisch angedeutet,
- Fig. 7: eine Darstellung der Anordnung der Fig. 1 von der Rückseite, gesehen in Richtung des Pfeiles VII der Fig. 4,
- Fig. 8: eine raumbildliche Darstellung der Anordnung nach den Fig. 1 bis 7, etwa analog Fig. 1,
- Fig. 9: eine Draufsicht auf eine Gehäusewand mit einer Ausnehmung, in der ein Lüfter nach einem zweiten Ausführungsbeispiel der Erfindung befestigt ist; Fig. 9 ist aus Gründen der Darstellung etwas vergrößert gezeichnet,
- Fig. 10: eine seitliche Ansicht, gesehen in Richtung des Pfeiles X der Fig. 9,
- Fig. 11: eine seitliche Ansicht, gesehen in Richtung des Pfeiles XI der Fig. 9,
- Fig. 12: eine seitliche Ansicht, gesehen in Richtung des Pfeiles XII der Fig. 9,
- Fig. 13: einen Schnitt, gesehen längs der Linie XIII-XIII der Fig. 9 in stark vergrößerter Darstellung; der Motor ist nur schematisch angedeutet und befindet sich in seiner Stellung nach der Montage,
- Fig. 14: eine Darstellung der Anordnung der Fig. 9 von der Rückseite, gesehen in Richtung des Pfeiles XIV der Fig. 12, und
- Fig. 15: eine raumbildliche Darstellung der Anordnung nach den Fig. 9 bis 14, gesehen etwa analog Fig. 9.

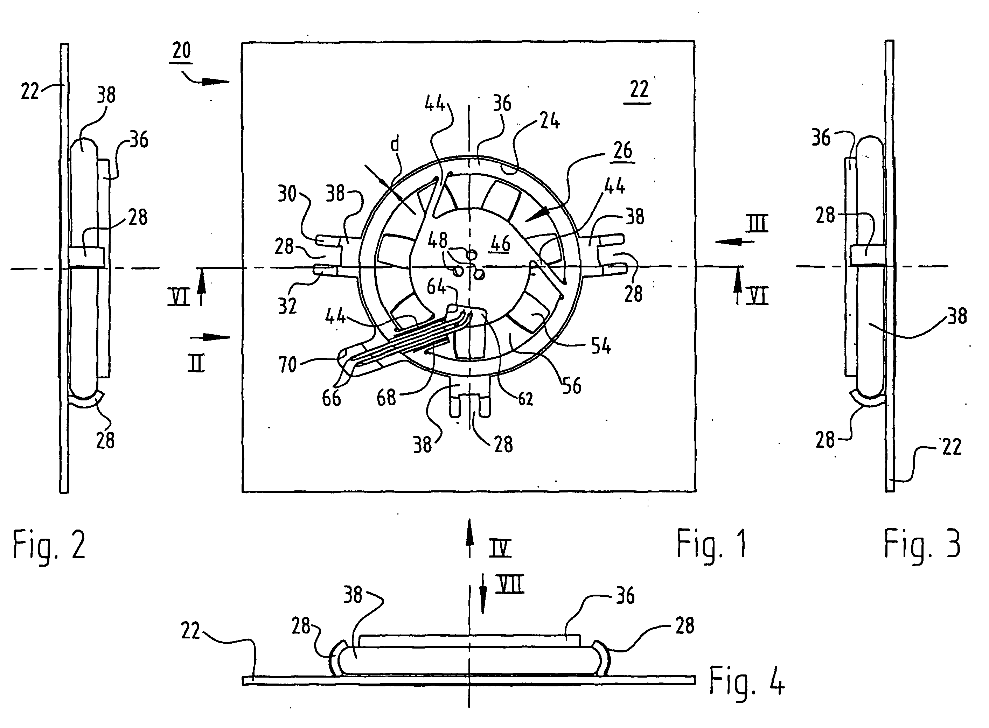

**Fig. 1** zeigt eine Anordnung 20 mit einer Wand 22, in der sich eine im wesentlichen kreisrunde Ausnehmung 24 befindet, in der ein im wesentlichen kreisrunder Lüfter 26 schwingungsarm befestigt ist. Der Lüfter 26 hat einen Abstand d vom Rand der Ausnehmung 24, damit kein Körperschall direkt von ihm auf die Wand 22 übertragen werden kann.

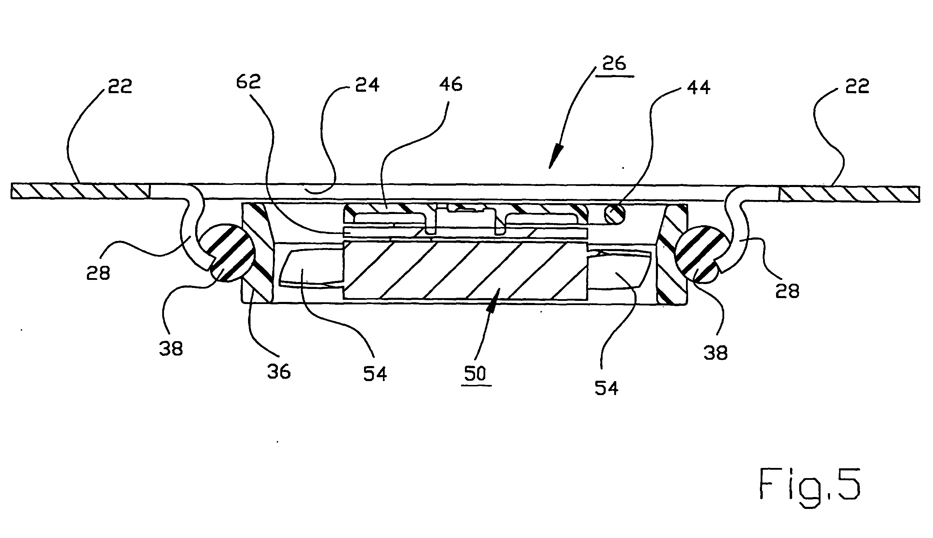

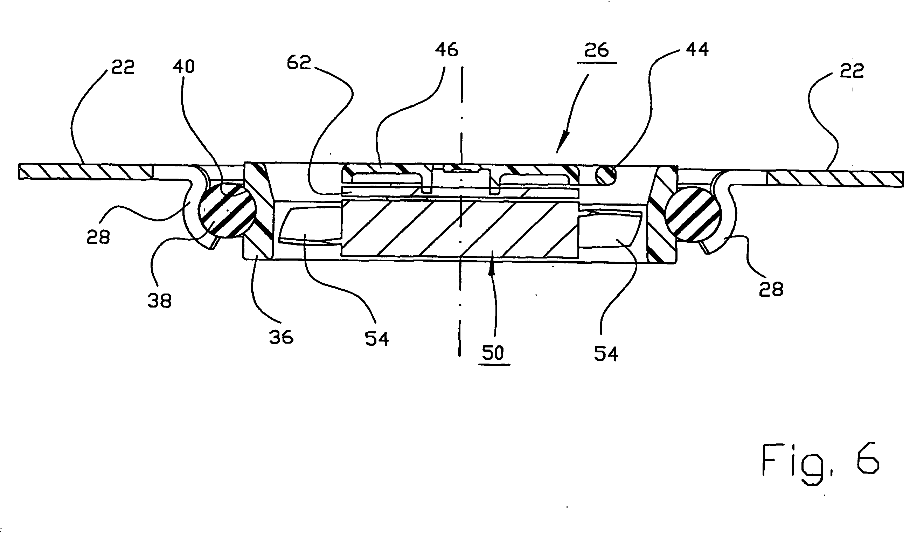

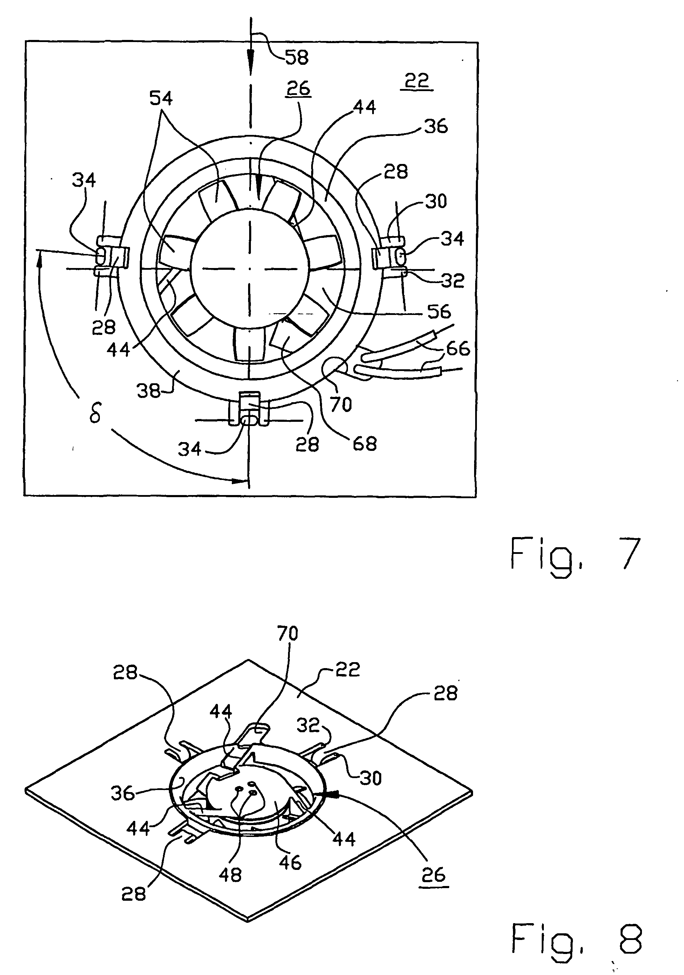

Am Rand der Ausnehmung 24 ist eine Mehrzahl von Haltegliedern 28 ausgebildet, deren Form am besten aus Fig. 1 und 5 hervorgeht. Bei der ersten Ausführungsform gemäß Fig. 1 bis 8 federn die Halteglieder 28 im wesentlichen in radialer Richtung. Sie sind jeweils gebildet durch zwei parallele Stanzschnitte 30, 32, welche, bezogen auf die Ausnehmung 24, etwa radial nach außen verlaufen, und sie sind in der in Fig. 5 und 6 dargestellten Weise zu federnden Laschen bzw. Haltekrallen gebogen, die bei der Montage/Demontage etwas in radialer Richtung nach außen ausfedern können. Im Bereich ihrer Wurzeln sind die Halteglieder 28 zur Versteifung bevorzugt mit einer Sicke 34 versehen, vgl. Fig. 7.

Wie besonders aus Fig. 6 hervorgeht, hat der Lüfter 26 zur Luftführung ein äußeres Gehäuseteil 36, das bei dieser Ausführungsform im wesentlichen rund ist, aber auch eine andere Form haben könnte, und auf dem in geeigneter Weise ein ringförmiges elastomeres Teil befestigt ist, hier in Form eines O-Rings 38 aus Gummi oder dergleichen. Der O-Ring 38 ist mit einer Ringnut 40 des Gehäuseteils 36 stoff- oder kraftschlüssig verbunden, z.B. durch Kleben, Vulkanisieren oder dgl. Im montierten Zustand liegt er mit elastischer Vorspannung sowohl gegen die drei Halteglieder 28 wie gegen die Gehäusewand 22 an und dichtet dadurch das Gehäuseteil 36 des Lüfters 26 weitgehend gegen die Gehäusewand 22 ab, vgl. Fig. 6.

Das Gehäuseteil 36 ist über eine Mehrzahl von schräg verlaufenden Stegen 44 mit einer zentralen Nabe 46 verbunden, an welcher mittels Schrauben 48 oder - bevorzugt - mittels einer Pressverbindung ein Außenläufermotor 50 befestigt ist, der in Fig. 5 und 6 nur ganz schematisch dargestellt ist. Auf seinem Außenrotor 52 (Fig. 7) sind Lüfterflügel 54 befestigt, die in einem Raum 56 zwischen Gehäuseteil 36 und Außenrotor 52 rotieren. In Fig. 5 und 6 wird die Luft nach oben ausgeblasen, also zwischen den Stegen 44. Es ist ohne weiteres ersichtlich, dass sich die Erfindung für verschiedene Lüftertypen eignet, z.B. für Axiallüfter, Diagonallüfter und Radiallüfter. Ein wichtiges Anwendungsgebiet sind Axial-Minilüfter.

Zur Montage wird der Lüfter 26 in Fig. 7 von oben längs der Gehäusewand 22 in Richtung eines Pfeiles 58 verschoben, also zwischen zwei gegenüberliegenden Haltegliedern 28, wie das aus Fig. 7 klar hervor geht.

Dabei gleitet der Lüfter 26 gemäß Fig. 5 entlang der Gehäusewand 22, und bei Kontakt mit den Haltegliedern 28 wird der O-Ring 38 etwa so verformt, wie das in Fig. 5 leicht übertrieben dargestellt ist.

Schließlich erreicht der Lüfter 26 eine Stellung, wie sie in Fig. 6 dargestellt ist, und dabei schnappt sein Gehäuseteil 36 in die Ausnehmung 24 der Gehäusewand 22 ein, wobei sich also, bezogen auf Fig. 5 und 6, der Lüfter 26 unter der Wirkung der im O-Ring 38 gespeicherten Energie nach oben bewegt und bevorzugt etwas aus der Gehäusewand 22 herausragt. Dabei legt sich der O-Ring 38 mit Vorspannung gegen die Wand 22, wie ein Vergleich der Fig. 5 und 6 klar zeigt, und bildet so bei der Montage gleichzeitig einen Anschlag und eine Dichtung, welche das Gehäuseteil 36 gegen die Wand 22 abdichtet. Dabei verbleiben im Bereich der Halteglieder 28 kleine Öffnungen, die ggf. noch mit einem Selbstklebestreifen überklebt werden können. Diese Öffnungen entsprechen im wesentlichen den Schlitzen 30 und 32.

Der Motor 50 benötigt eine Stromzufuhr und hat zu diesem Zweck eine Leiterplatte 62 mit elektronischen Bauelementen. Die Leiterplatte 62 ist über eine Aussparung 64 (Fig. 1) der Nabe 46 zugänglich. Im Bereich dieser Aussparung werden Leitungen 66 angelötet und über eine am Gehäuseteil 36 befestigte Brücke 68 zu einer Öffnung 70 der Wand 22 und durch diese Öffnung 70 hindurch geführt, um dem Motor 50 Strom zuzuführen.

Die Demontage des Lüfters 26 erfolgt in umgekehrter Reihenfolge wie die Montage, d.h. in Fig. 6 wird der Lüfter 26 nach unten gedrückt und dann entgegengesetzt zum Pfeil 58 der Fig. 7 seitlich aus den Halterungen 28 heraus geschoben.

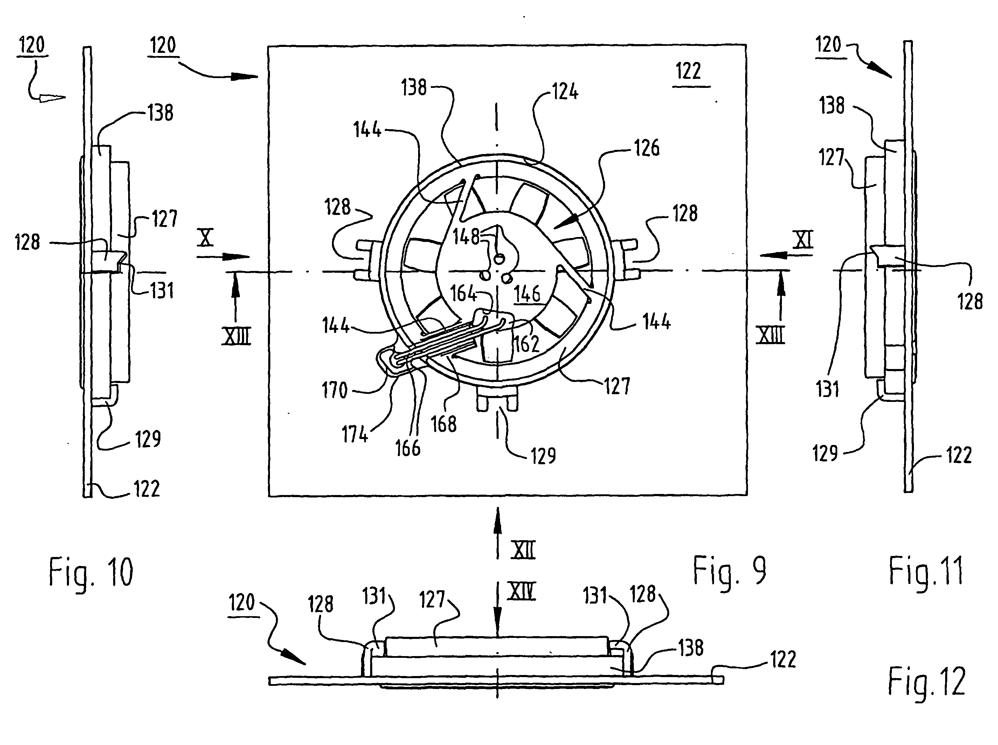

Die **Fig. 9 bis 15** zeigen eine zweite Ausführungsform der Erfindung. Im Vergleich zur Ausführungsform nach den Fig. 1 bis 8 ist die zweite Ausführungsform preiswerter herzustellen, und bei ihr ist eine nachträgliche Demontage des Lüfters nur mit hohem Kraftaufwand möglich. Auch ist bei dieser Variante eine Zugentlastung für die Anschlussleitungen vorgesehen.

Zwischen der ersten und der zweiten Ausführungsform bestehen Gemeinsamkeiten. Deshalb werden gleiche oder gleich wirkende Teile in den Fig. 9 bis 15 mit Bezugszeichen bezeichnet, die gegenüber den Fig. 1 bis 8 um 100 erhöht sind, z.B. 122 statt 22. Diese Teile werden gewöhnlich nicht nochmals beschrieben.

Die Anordnung 120 hat eine Wand 122, in der sich eine Ausnehmung 124 befindet, in welche ein Lüfter 126 mit einem Gehäuseabschnitt 127 hineinragt. Die Ausnehmung 124 und der Gehäuseabschnitt 127 sind hinsichtlich ihrer Form komplementär, z.B. wie dargestellt im wesentlichen rund.

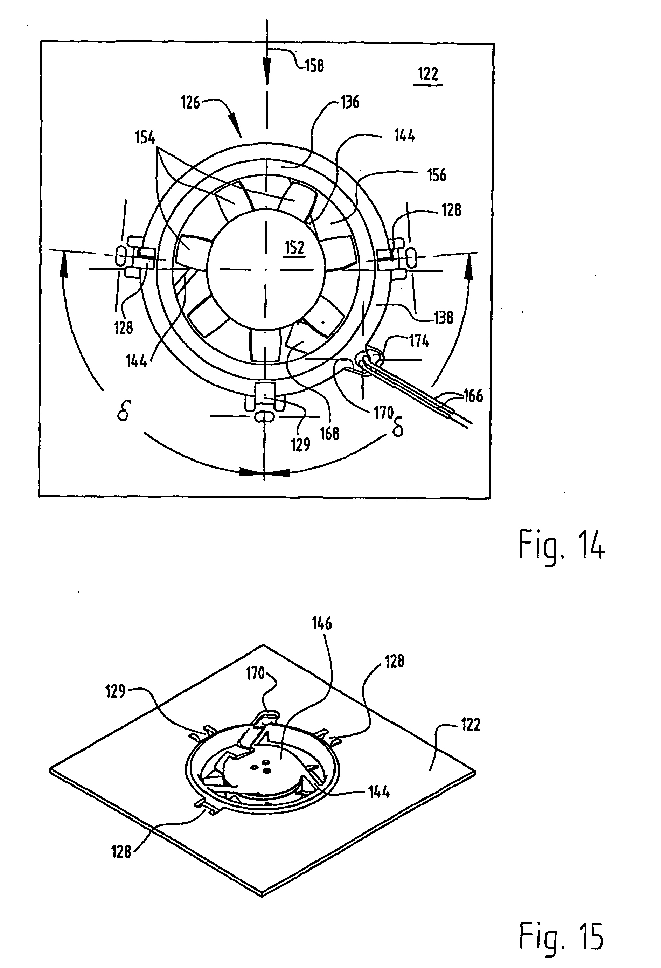

An der inneren Peripherie der Ausnehmung 124 ist eine Mehrzahl von Haltegliedern oder Haltekrallen 128, 129 ausgebildet. Die beiden Halteglieder 128 liegen einander gegenüber und führen den Lüfter 126 bei seiner Montage ähnlich wie die seitlichen Führungen eine Schublade führen, und in das Halteglied 129 greift der Lüfter 126 praktisch erst bei Erreichen seiner Montagestellung ein. Wie **Fig. 14** zeigt, schließt jedes der Halteglieder 128 mit dem Halteglied 129 einen Winkel ∂ ein, der größer ist als 90°, z.B., wie dargestellt, 94°. Dies gilt in gleicher Weise für die Fig. 1 bis 8. Der Grund ist, dass durch diese Anordnung ein unerwünschtes Lösen des Lüfters 26 bzw. 126 aus seiner montierten Stellung verhindert wird. Wie man erkennt, wäre auch bei Winkeln ∂ von 90° oder sogar weniger die Befestigung außerordentlich sicher.

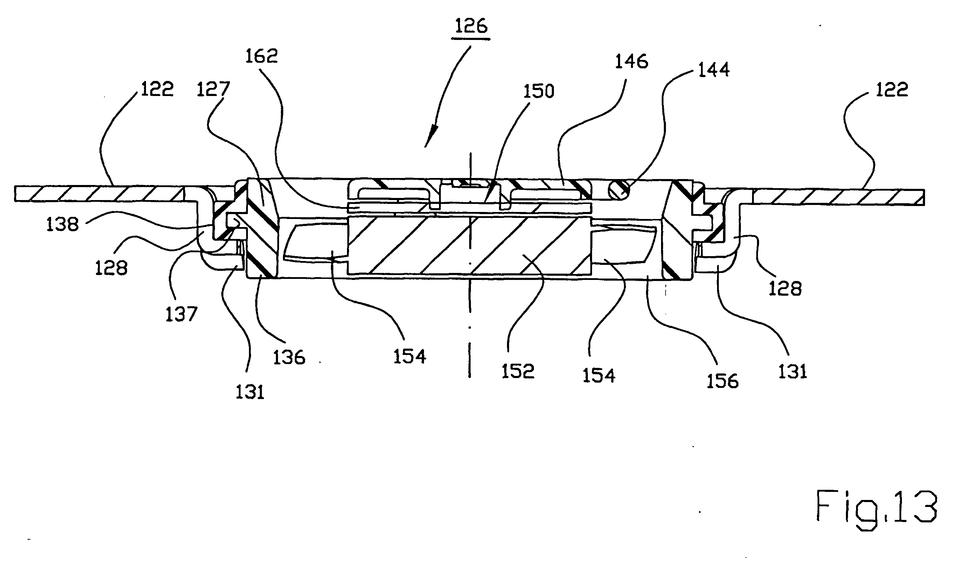

Wie aus **Fig. 13** hervorgeht, hat der Lüfter 126 zur Luftführung ein äußeres Gehäuseteil 136, dessen in Fig. 13 oberer Abschnitt 127 im montierten Zustand in die Ausnehmung 124 ragt. An seinem Außenumfang hat das Gehäuseteil 136 einen radial vorspringenden Flansch 137. Dieser ist auf allen drei Seiten von einer Auflage 138 aus einem elastomeren Werkstoff umgeben, die sich in Fig. 13 bis zum oberen Ende des Abschnitts 127 erstreckt. Die Auflage 138 kann z.B. aus Gummi bestehen, und sie wird bevorzugt zusammen mit dem Gehäuseteil 136 im Zweikomponenten-Spritzgussverfahren hergestellt. Wie Fig. 13 zeigt, liegt die Auflage 138 im montierten Zustand mit Vorspannung gegen die Wand 122 an und wirkt dadurch als Anschlag und als Dichtung zwischen dem Gehäuseteil 136 und der Wand 122. Wie in Fig. 9 dargestellt, füllt sie auch einen Spalt zwischen der Ausnehmung 124 und dem Abschnitt 127.

Die **Fig. 10 und 11** zeigen, dass das Halteglied 129 die Form eines einfachen Hakens hat, in welchen bei der Montage der Flansch 137 mit seiner Auflage 138 hineingeschoben wird. Dagegen haben die seitlichen Halteglieder 128 eine Form dergestalt, dass sich die von ihnen gebildete Ausnehmung durch eine schräge Fläche 131 nach oben hin erweitert, bezogen auf die Fig. 10 und 11. Die schrägen Flächen oder Wände 131 dienen zur Erleichterung der Montage.

Das äußere Gehäuseteil 136 ist über eine Mehrzahl von schräg verlaufenden Stegen 144 mit einer zentralen Nabe 146 des Lüfters verbunden, an welcher mittels Schrauben 148 oder - bevorzugt - mittels einer Pressverbindung ein Außenläufermotor 150 befestigt ist, der in Fig. 13 nur stark schematisiert dargestellt ist. Auf seinem Außenrotor 152 (Fig. 14) sind Lüfterflügel 154 befestigt, die in einem Raum 156 zwischen äußerem Gehäuseteil 136 und Außenrotor 152 rotieren. In Fig. 13 wird die Luft nach oben ausgeblasen, also zwischen den Stegen 144.

Zur Montage wird der Lüfter 126 in Fig. 14 in einer Zwangs-Translationsbewegung von oben nach unten längs der Gehäusewand 122 in Richtung eines Pfeiles 158 verschoben, also zwischen den beiden gegenüberliegenden Haltegliedern 128, wie das Fig. 13 und 14 klar zeigen.

Dabei gleitet der Lüfter 126 - analog Fig. 5 - entlang der Gehäusewand 122, und bei Kontakt mit den Haltegliedern 128 wird seine Elastomer-Auflage 138 entsprechend elastisch verformt, wodurch in ihr potenzielle Energie gespeichert wird. In Fig. 13 ist das der untere Teil der Auflage 138, der verformt wird, was aber in Fig. 13 nicht dargestellt ist.

Schließlich endet die Translationsbewegung des Lüfters 126 in einer Stellung, wie sie z.B. in Fig. 13 dargestellt ist, und dabei schnappt sein Gehäuseabschnitt 127 in die Ausnehmung 124 der Gehäusewand 122 ein, wobei sich also, bezogen auf Fig. 13, der Lüfter 126 unter der Wirkung der in der Elastomer-Auflage 138 gespeicherten Energie nach oben bewegt und danach bevorzugt etwas aus der Gehäusewand 122 herausragt. Dabei legt sich die Auflage 138 mit Vorspannung gegen die Wand 122 und bildet so bei der Montage automatisch einen Anschlag und eine Dichtung, welche das äußere Gehäuseteil 136 gegen die Wand 122 abdichtet. Die potentielle Energie, welche während der Translationsbewegung in der Auflage 138 gespeichert wurde, wird also in dieser Stellung teilweise in kinetische Energie umgewandelt, welche den Lüfter endgültig in seine montierte Stellung bewegt und dabei einen Druck auf den Teil der Auflage 138 aufrecht erhält, der in der montierten Stellung als Dichtung wirkt.

Im Bereich der Halteglieder 128, 129 verbleiben kleine Öffnungen, die ggf. noch mit einem Selbstklebestreifen überklebt werden können. Diese Öffnungen entsprechen im wesentlichen den Schlitzen 30 und 32 der Fig. 8.

Der Motor 150 benötigt eine Stromzufuhr und hat zu diesem Zweck eine Leiterplatte 162 mit elektronischen Bauelementen. Die Leiterplatte 162 ist über eine Aussparung 164 (Fig. 9) der Nabe 146 zugänglich. Im Bereich dieser Aussparung werden Leitungen 166 angelötet und über eine am Gehäuseteil 136 befestigte Brücke 168 zu einer Öffnung 170 der Wand 122 und durch diese Öffnung 170 hindurch geführt, um dem Motor 150 Strom zuzuführen.

An der Elastomer-Auflage 138 ist bei dieser Ausführungsform eine KabelZugentlastung 174 stoffschlüssig angeformt, die aus demselben Elastomer hergestellt ist und deren an sich bekannte Form aus den Fig. 9 und 14 hervorgeht. Sie verhindert, dass bei starkem Zug auf die Leitungen 166 diese von der Leiterplatte 162 abgerissen werden. Gleichzeitig verhindert sie, dass die Isolation der Leitungen 166 durch den Blechrand der Öffnung 170 beschädigt wird.

Die seitlichen Öffnungen 70, 170 liegen bevorzugt im Bereich eines der Winkel ∂ der Fig. 14, also zwischen zwei benachbarten Halteklammern 128, 129, weil das die Montage der Zugentlastung 174 vereinfacht.

Die Erfindung verwendet also eine Zwangs-Translationsbewegung des Lüfters in Richtung zu einer Öffnung, an der dieser Lüfter installiert werden soll, dazu, um potenzielle Energie zu speichern, z.B. durch elastische Verformung eines elastischen Glieds. Die Translationsbewegung erfolgt quer zur Achse dieser Öffnung.

Bei Erreichen der gewünschten Stellung gegenüber der Öffnung wird mindestens ein Teil dieser gespeicherten potenziellen Energie in kinetische Energie umgewandelt, um einen Bestandteil des Lüfters in diese Öffnung zu bewegen und dabei gleichzeitig ein Dichtglied zu aktivieren, das eine Dichtung zwischen dem Gehäuse des Lüfters und einer die Öffnung umgebenden Wand herstellt. Bevorzugt wird ein Teil der bei der Translationsbewegung gespeicherten Energie dazu verwendet, eine ständige Kraft auf diese Dichtung zu erzeugen, d.h. auch im montierten Zustand des Lüfters bleibt bevorzugt etwas potenzielle Energie gespeichert, um den abgedichteten Zustand ständig aufrecht zu erhalten. Die Dichtung wirkt dabei gleichzeitig als Anschlag.

Durch ein geschicktes "Energiemanagement" beim Montagevorgang wird also die Montage solcher Minilüfter sehr einfach und preiswert, wobei zusätzlich der Vorteil entsteht, dass die direkte Übertragung von Körperschall vom Lüfter auf ein umgebendes Gehäuse zumindest stark reduziert werden kann. Die Variante nach den Fig. 9 bis 15 hat gegenüber derjenigen nach Fig. 1 bis 8 den Vorteil, dass sie sich besonders gut zur Montage von Minilüftern eignet, deren Gehäuseform von der Kreisform abweicht, z.B. von Lüftern mit einer quadratischen Gehäuseform, und zur Montage in einer Gehäuseöffnung, die ebenfalls etwa die Form eines Quadrats hat.

Naturgemäß sind im Rahmen der vorliegenden Erfindung vielfache Abwandlungen und Modifikationen möglich. Insbesondere ist die Gestaltung der Elastomer-Auflage 38 bzw. 138 in weiten Grenzen variabel, solange deren wesentliche Funktionen erhalten bleiben, nämlich die zuverlässige Abdichtung zwischen Lüfter und Wand, die Erleichterung der Montage/Demontage durch elastische Verformung dieses Elastomers, und die Funktion als Anschlag und als Abdichtung im montierten Zustand. Besonders bei der Auflage 138 wird sichtbar, dass deren Teile im Rahmen der Erfindung unterschiedliche Funktionen haben (können).

## Patentansprüche

1. Minilüfter (26; 126) zur Montage in einer Ausnehmung (24; 124) einer Wand (22; 122), welche Wand an der Peripherie der Ausnehmung (24; 124) mit einer Mehrzahl von Haltegliedern (28; 128, 129) versehen ist, welcher Lüfter zur Luftführung ein Gehäuse (36; 136) aufweist, das in seiner montierten Stellung mit einem zur Ausnehmung (24; 124) der Wand (22; 122) etwa komplementären Gehäuseabschnitt (127) in die Ausnehmung (24; 124) der Wand (22; 122) ragt,
**dadurch gekennzeichnet, dass** Minilüfter mindestens ein an der Peripherie dieses Gehäuseabschnitts angeordnetes Teil (38; 138) aus einem elastomeren Werkstoff aufweist, mit welchem Teil der Lüfter (26; 126) bei seiner Montage unter Verschiebung längs der Wand (22; 122) in die Halteglieder (28; 128, 129) einführbar (Fig. 14: 158) ist, um dieses Teil (38; 138) in-der montierten Stellung mindestens bereichsweise zur dichtenden Anlage gegen die Wand (22; 122) zu bringen.

2. Minilüfter nach Anspruch 1, bei welchem das Teil (38; 138) aus elastomerem Werkstoff bei der längs der Wand (22; 122) erfolgenden Bewegung (Fig. 14: 158) elastisch verformbar ist, um in ihm Energie zu speichern, durch welche der Gehäuseabschnitt in seiner montierten Stellung in die Ausnehmung (24; 124) der Wand bewegbar ist.

3. Minilüfter nach Anspruch 1 oder 2, bei welchem das Teil aus elastomerem Werkstoff etwa nach Art eines O-Rings (38) ausgebildet und am Umfang des Lüftergehäuses (36) befestigt ist.

4. Minilüfter nach Anspruch 3, bei welchem das Teil (38) aus elastomerem Werkstoff in einer Nut am Umfang des Lüftergehäuses (36) befestigt ist.

5. Minilüfter nach Anspruch 1 oder 2, bei welchem das Lüftergehäuse (136) an seinem Umfang mit einem flanschartigen Vorsprung (137) versehen ist, und dieser flanschartige Vorsprung (137) mindestens bereichsweise mit einer Auflage (138) aus elastomerem Werkstoff versehen ist.

6. Minilüfter nach Anspruch 5, bei welchem die Auflage (138) aus elastomerem Werkstoff so ausgebildet ist, dass sie im montierten Zustand des Lüfters mindestens bereichsweise dichtend gegen die Wand (122) anliegt.

7. Minilüfter nach einem der vorhergehenden Ansprüche, welcher zur Befestigung in einer Ausnehmung (24; 124) ausgebildet ist, an deren Peripherie radial federnde Halteglieder (28) für den Lüfter vorgesehen sind.

8. Minilüfter nach einem der vorhergehenden Ansprüche, welcher zur Montage an einer Wand ausgebildet ist, bei welcher mindestens ein Teil der Halteglieder (128) auf der Seite, auf welcher der Lüfter (126) bei der Montage eingeführt wird, eine vergrößerte Einführöffnung (131) aufweist.

9. Minilüfter nach einem der vorhergehenden Ansprüche, bei welchem der Teil des Lüfters (26; 126), welcher nach der Montage in die Ausnehmung (24; 124) der Wand ragt, im wesentlichen komplementär zur Form dieser Ausnehmung (24; 124) ausgebildet ist.

10. Minilüfter nach einem der vorhergehenden Ansprüche, bei welchem mit dem Teil aus elastomerem Werkstoff ein Zugentlastungsglied (174) verbunden ist, welches zur Zugentlastung eines elektrischen Anschlusskabels (166) des Lüfters (26; 126) ausgebildet ist.

11. Minilüfter nach Anspruch 10, bei welchem das Zugentlastungsglied (174) stoffschlüssig mit dem Teil (138) aus elastomerem Werkstoff verbunden ist.

12. Minilüfter nach Anspruch 10 oder 11, bei welchem das Zugentlastungsglied (174) zur Anordnung in einer Durchbrechung (170) der Wand (122) ausgebildet ist.

13. Minilüfter nach Anspruch 12, bei welchem das Zugentlastungsglied (174) zur abgedichteten Anordnung in der Durchbrechung (170) der Wand (122) ausgebildet ist.

14. Anordnung mit einer Wand, welche mit einer Ausnehmung versehen ist, an deren Peripherie Halteglieder vorgesehen sind, wobei an dieser Wand ein Minilüfter nach einem der vorhergehenden Ansprüche montiert ist.

## Claims

1. Miniature fan (26; 126) for mounting in a recess (24; 124) in a wall (22; 122), which wall is provided with a plurality of retaining members (28; 128, 129) at the periphery of the recess (24; 124), which fan for guidance of the air comprises a housing (36; 136) which in its mounted position projects into the recess (24; 124) in the wall (22; 122) with a housing portion (127) which is roughly complementary to the recess (24; 124) in the wall (22; 122), **characterised in that** the miniature fan comprises at least one part (38; 138) which is made of an elastomer material and arranged on the periphery of this housing portion, with which part the fan (26; 126) can be introduced into the retaining members (28; 128, 129) during its mounting when it is moved along the wall (22; 122) (Fig. 14: 158) in order to bring this part (38; 138) into sealing contact against the wall (22; 122) at least in areas in the mounted position.

2. Miniature fan according to claim 1, in which the part (38; 138) made of elastomer material is elastically deformable during the movement along the wall (22; 122) (Fig. 14: 158) in order to store in it energy through which the housing portion can be moved into the recess (24; 124) in the wall in its mounted position.

3. Miniature fan according to claim 1 or 2, in which the part made of elastomer material is roughly embodied like an O ring (38) and is fastened to the circumference of the fan housing (36).

4. Miniature fan according to claim 3, in which the part (38) made of elastomer material is fastened in a groove on the circumference of the fan housing (36).

5. Miniature fan according to claim 1 or 2, in which the fan housing (136) is provided at its circumference with a flange-like projection (137), and this flange-like projection (137) is provided at least in areas with a support (138) made of elastomer material.

6. Miniature fan according to claim 5, in which the support (138) made of elastomer material is embodied so that it bears sealingly against the wall (122) at least in areas in the mounted state of the fan.

7. Miniature fan according to one of the preceding claims, which is embodied for fastening in a recess (24; 124) on the periphery of which there are radially resilient retaining members (28) for the fan.

8. Miniature fan according to one of the preceding claims, which is embodied for mounting on a wall, in which at least one part of the retaining members (128) comprises an enlarged introduction opening (131) on the side on which the fan (126) is introduced during mounting.

9. Miniature fan according to one of the preceding claims, in which the part of the fan (26; 126) which projects into the recess (24; 124) in the wall after mounting is essentially embodied so as to be complementary to the shape of this recess (24; 124).

10. Miniature fan according to one of the preceding claims, in which a strain relief member (174) which is embodied for strain relief of an electrical connecting cable (166) of the fan (26; 126) is connected to the part made of elastomer material.

11. Miniature fan according to claim 10, in which the strain relief member (174) is connected in a materially intimate fashion to the part (138) made of elastomer material.

12. Miniature fan according to claim 10 or 11, in which the strain relief member (174) is embodied for location in an opening (170) in the wall (122).

13. Miniature fan according to claim 12, in which the strain relief member (174) is embodied for sealed location in the opening (170) in the wall (122).

14. Arrangement with a wall which is provided with a recess on the periphery of which retaining members are provided, with a miniature fan according to one of the preceding claims mounted on this wall.

## Revendications

1. Miniventilateur (26 ; 126) conçu pour le montage dans un évidement (24 ; 124) d'une paroi (22 ; 122), laquelle paroi est munie d'une pluralité d'organes de retenue (28 ; 128, 129) à la périphérie de l'évidement (24 ; 124), ledit ventilateur comportant, pour l'amenée ou le guidage d'air, un boîtier (36 ; 136) qui, dans sa position montée, s'engage dans l'évidement (24 ; 124) de la paroi (22 ; 122) par une région (127) sensiblement complémentaire dudit évidement (24 ; 124) de la paroi (22 ; 122), **caractérisé par le fait que** le miniventilateur présente au moins une partie (38 ; 138) en un matériau élastomère située à la périphérie de ladite région du boîtier, partie au moyen de laquelle le ventilateur (26 ; 126) peut être inséré (figure 14 : 158) dans les organes de retenue (28 ; 128, 129) au cours de son montage, par coulissement le long de la paroi (22 ; 122), afin d'établir au moins par zones, dans la position montée, un contact étanche de cette partie (38 ; 138) avec ladite paroi (22 ; 122).

2. Miniventilateur selon la revendication 1, dans lequel la partie (38 ; 138) en un matériau élastomère est déformable élastiquement, au cours du mouvement (figure 14 : 158) s'opérant le long de la paroi (22 ; 122), afin de stocker, dans ladite partie, de l'énergie par l'intermédiaire de laquelle la région du boîtier peut être engagée, dans sa position montée, dans l'évidement (24 ; 124) de la paroi.

3. Miniventilateur selon la revendication 1 ou 2, dans lequel la partie en un matériau élastomère est sensiblement réalisée à la manière d'une bague torique (38) et est fixée sur le pourtour du boîtier (36) dudit ventilateur.

4. Miniventilateur selon la revendication 3, dans lequel la partie (38) en un matériau élastomère est fixée dans une rainure pratiquée sur le pourtour du boîtier (36) dudit ventilateur.

5. Miniventilateur selon la revendication 1 ou 2, dans lequel le boîtier (136) dudit ventilateur est pourvu, sur son pourtour, d'une protubérance (137) du type collerette et cette protubérance (137) du type collerette est dotée, au moins par zones, d'une pièce d'appui (138) en un matériau élastomère.

6. Miniventitateur selon la revendication 5, dans lequel la pièce d'appui (138) en un matériau élastomère est réalisée de façon telle qu'elle soit appliquée de manière étanche contre la paroi (122), au moins par zones, à l'état monté dudit ventilateur.

7. Miniventilateur selon l'une des revendications précédentes, conçu pour la fixation dans un évidement (24 ; 124) à la périphérie duquel des organes de retenue (28), doués d'élasticité radiale, sont prévus pour ledit ventilateur.

8. Miniventilateur selon l'une des revendications précédentes, conçu pour le montage sur une paroi dans laquelle au moins une partie des organes de retenue (128) possède un orifice d'insertion (131) de taille agrandie du côté sur lequel ledit ventilateur (126) est introduit au cours du montage.

9. Miniventilateur selon l'une des revendications précédentes, dans lequel la partie dudit ventilateur (26 ; 126) s'engageant dans l'évidement (24 ; 124) de la paroi à l'issue du montage est, pour l'essentiel, d'une réalisation complémentaire de la forme de cet évidement (24 ; 124).

10. Miniventilateur selon l'une des revendications précédentes, dans lequel un organe (174) de soulagement en traction, relié à la partie en un matériau élastomère, est conçu pour soulager en traction un câble (166) de raccordement électrique dudit ventilateur (26 ; 126).

11. Miniventilateur selon la revendication 10, dans lequel l'organe (174) de soulagement en traction est en liaison matérielle avec la partie (138) en un matériau élastomère.

12. Miniventilateur selon la revendication 10 ou 11, dans lequel l'organe (174) de soulagement en traction est conçu pour être placé dans une perforation (170) de la paroi (122).

13. Miniventilateur selon la revendication 12, dans lequel l'organe (174) de soulagement en traction est conçu pour être placé, de manière étanche, dans la perforation (170) de la paroi (122).

14. Agencement comportant une paroi munie d'un évidement à la périphérie duquel des organes de retenue sont prévus, un miniventilateur conforme à l'une des revendications précédentes étant monté sur cette paroi.
